Europäisches Patentamt

European Patent Office

Office européen des brevets

(19)

(11) Publication number : **0 497 556 A1**

(12) # EUROPEAN PATENT APPLICATION

(21) Application number : 92300717.3

(22) Date of filing : 28.01.92

(51) Int. Cl.⁵ : **H01F 27/28, H01F 5/00**

(30) Priority : **30.01.91 JP 31998/91**

(43) Date of publication of application :
**05.08.92 Bulletin 92/32**

(84) Designated Contracting States :
**DE GB**

(71) Applicant : **SHARP KABUSHIKI KAISHA**
**22-22 Nagaike-cho Abeno-ku**
**Osaka-shi Osaka-fu (JP)**

(72) Inventor : **Okamoto, Keiji**
**2-9, Imafuku-cho**
**Izumi-shi, Osaka-fu (JP)**
Inventor : **Kitaguchi, Masanori**
**3-13-20, Nishiura**
**Habikino-shi, Osaka-fu (JP)**
Inventor : **Seki, Kenichi**
**1886-41, Furuichi**
**Habikino-shi, Osaka-fu (JP)**

(74) Representative : **Brown, Kenneth Richard et al**
**R.G.C. Jenkins & Co. 26 Caxton Street**
**London SW1H 0RJ (GB)**

(54) **Print coil device for double tuning circuit.**

(57)    A print coil device for a double tuning circuit includes an insulator substrate (15), a first substantially spiral metallic foil pattern (12a) formed on a first face of substrate (15), and a second substantially spiral metallic foil pattern (13a) formed on a second face of substrate (15), wherein first and second spiral metallic foil patterns (12a, 13a) are not electrically connected with each other, and at least respective portions of first and second spiral metallic foil patterns (12a, 13a) are overlapped with each other with substrate (15) interposed therebetween so as to provide a mutual electromagnetic coupling.

FIG.4

EP 0 497 556 A1

## BACKGROUND OF THE INVENTION

### Field of the Invention

The present invention relates generally to a coil device incorporated in a double tuning circuit employed as a tuner circuit of electronics apparatus such as a television receiver, video recorder or the like and, more particularly, to a print coil device for a double tuning circuit suitable for small and thin electronics apparatus.

### Description of the Background Art

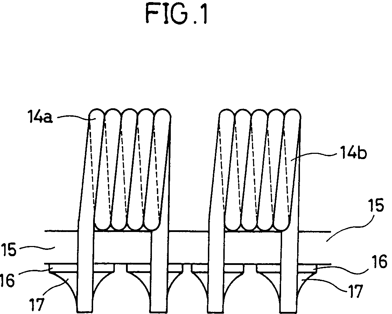

Fig. 1 shows a side face of a conventional coil device for a double tuning circuit including two air-core coils. This coil device is generally used in small and thin electronics apparatus. The coil device is structured such that two air-core coils 14a and 14b which are formed by winding in cylindrical form an electric wire coated with urethane, enamel or the like are connected by solder 17 onto a copper foil pattern 16 formed on an insulator substrate 15.

Air-core coils 14a and 14b of Fig. 1 requre a predetermined winding diameter. The winding diameter depends on a desired value of inductance, however, there is a problem that the winding diameter restricts implementation of a still thinner electronics apparatus.

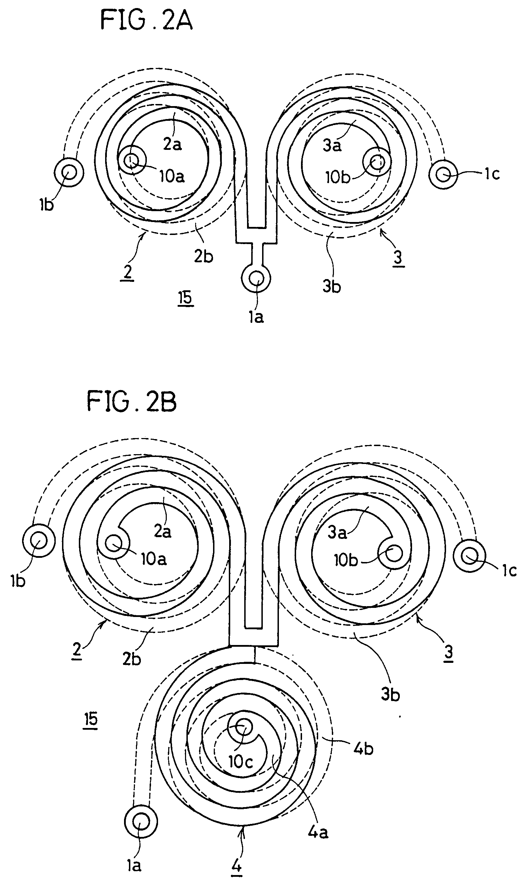

Fig.2A shows a print coil device for a double tuning circuit, including two spiral coils formed by patterning copper foils on both faces of the insulator substrate. A first coil 2 includes a first copper foil spiral 2a and a second copper foil spiral 2b, formed between two terminals 1a and 1b. First spiral 2a drawn by solid lines and second spiral 2b drawn by broken lines are formed respectively on a front face and a back face of insulator substrate 15 and are electrically connected with each other through a hole 10a in substrate 15. Similarly, a second coil 3 includes a first copper foil spiral 3a and a second copper foil spiral 3b, formed between two terminals 1a and 1c. First spiral 3a drawn by solid lines and second spiral 3b drawn by broken lines are formed respectively on the front face and the back face of insulator substrate 15 and are electrically connected with each other through a hole 10b in substrate 15. Incidentally, terminal 1a is grounded as to alternate current in a circuit.

The print coil device of Fig. 2A enables implementation of thinner electronics apparatus; however, there is a problem that since a sufficient electromagnetic coupling cannot be obtained between first and second coils 2 and 3, the print coil device cannot achieve a satisfactory characteristic to be used for a double tuning circuit.

Fig. 2B shows another print coil device for a double tuning circuit according to conventional art. The print coil device of Fig. 2B is similar to that of Fig. 2A and includes an additional third coil 4. That is, first and second coils 2 and 3 are connected to a terminal 1a through third coil 4. Third coil 4 includes first and second copper foil spirals 4a and 4b formed respectively on the front face and the back face of insulator substrate 15. First and second copper foil spirals 4a and 4b are connected with each other through a hole 10c in substrate 15. Incidentally, termianl 1a is grounded as to alternate current in a circuit.

Third coil 4 is provided to improve electromagnetic coupling between first and second coils 2 and 3; however, the print coil device of Fig. 2B requires substrate 15 with a larger area, thereby preventing implementation of smaller electronics apparatus.

## SUMMARY OF THE INVENTION

In view of the above-described conventional art, an object of the present invention is to provide a print coil device which enables implementation of smaller and thinner electronics apparatus and has a good characteristic for a double tuning circuit.

A print coil device for a double tuning circuit in accordance with the present invention includes an insulator substrate, a first substantially spiral metalic foil pattern formed on a first face of the insulator substrate, and a second substantially spiral metallic foil pattern formed on a second face of the insulator substrate, wherein the first and second spiral metallic foil patterns are not electrically connected with each other, at least respective portions of which are overlapped with each other with the insulator substrate interposed therebetween so as to provide mutual electromagnetic coupling.

The foregoing and other objects, features, aspects and advantages of the present invention will become more apparent from the following detailed description of the present invention when taken in conjunction with the accompaning drawings.

## BRIEF DESCRIPTION OF THE DRAWINGS

Fig. 1 is a side view of a coil device for a double tuning circuit including two conventional winding type coils.

Fig. 2A is a plan view of a print coil device for a double tuning circuit according to conventional art.

Fig. 2B is a plan view of another print coil device for a double tuning circuit according to conventional art.

Fig. 3 is a plan view of a print coil device for a double tuning circuit according to one embodiment of the present invention.

Fig. 4 is a perspective view of the print coil device of Fig. 3.

## DESCRIPTION OF THE PREFERRED EMBODIMENTS

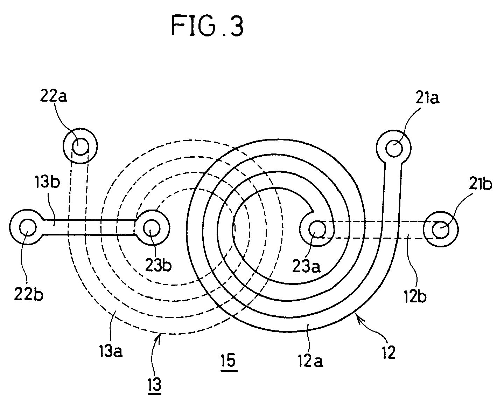

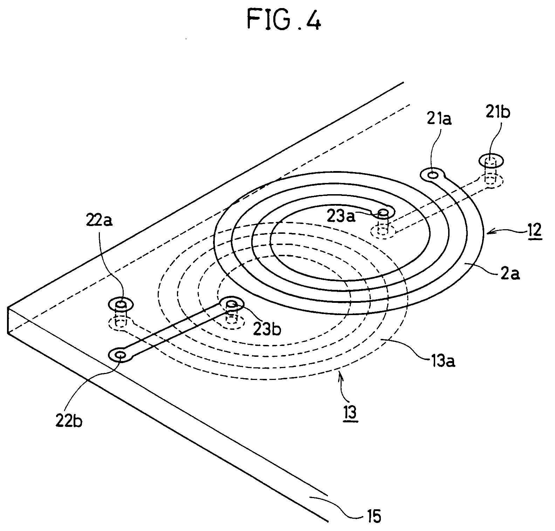

With reference to Figs. 3 and 4, a print coil device for a double tuing circuit according to one embodiment of the prsent invention is schematically illustrated. This print coil device includes two coils 12 adn 13 formed by patterning copper foils on both faces fo an insulator substrate 15. First coil 12 formed between terminals 21a and 21b includes a copper foil spiral 12a which is formed on a front face of substrate 15 as drawn by solid lines, and a copper foil lead 12b which is formed on a back face of substrate 15 as drawn by broken lines. Spiral 12a has an inner end portion connected to one end of lead 12b through a hole 23a in substrate 15. Lead 12b has the other end connected to terminal 21b penetrating substrate 15.

Similarly, second coil 13 formed between terminals 22a and 22b includes a copper foil spiral 13a which is formed on the back face of substrate 15 as drawn by broken lines, and a copper foil lead 13b which is formed on the front face of substrate 15 as drawn by solid lines. Spiral 13a has an inner end portion connected to one end of lead 13b through a hole 23b in substrate 15. Lead 13b has the other end connected to terminal 22b. On the other hand, spiral 13a has an outer end portion connected to terminal 22a penetrating substrate 15.

As can be understood from Figs. 3 and 4, first spiral 12 and second spiral 13 are not electrically connected with each other. However, at least a portion of first spiral 12a and that of second spiral 13a are overlapped with each other with insulator substrate 15 interposed therebetween. That is, at least a portion of magnetic flux generated by first coil 12, for example, passes the inside of second coil 13. Therefore, the print coil device of this embodiment ensures electromagnetic coupling without an additional third coil for electromagnetic coupling as shown in Fig. 2B. Further, the print coil device of this embodiment can achieve a desired degree of electromagnetic coupling by adjusting the proportion of overlapping of first and second spirals 12a and 13a.

Consequently, the print coil device of this embodiment allows implementation of a thinner electronics apparatus as compared to the coil device of Fig. 1 and a smaller electronics apparatus as compared to the print coil device of Fig. 2B. In addition, this print coil device can achieve superior electromagnetic coupling to the print coil device of Fig. 2A. Also, in the print coil device of this embodiment, all terminals 21a, 21b, 22a and 22b are exposed on the front face of substrate 15, and other circuits can be connected between those terminals by printed wiring only on the front face thereof.

While circular spiral coils have been described in the foregoing embodiment, it is needless to say that triangular, quadrangular or polygonal spiral coils can also be utilized.

While the print coils are formed of copper foils in the foregoing embodiment, it would be apparent that such print coils may be formed of other metallic foils such as of aluminum.

Although the present invention has been described and illustrated in detail, it is clearly understood that the same is by way of illustration and example only and is not to be taken by way of limitation, the spirit and scope of the present invention being limited only by the terms of the appended claims.

There are described above novel features which the skilled man will appreciate give rise to advantages. These are each independent aspects of the invention to be covered by the present application, irrespective of whether or not they are included within the scone of the following claims.

## Claims

1. A print coil device for a double tuning circuit, comprising:
   an insulator substrate (15);
   a first substantially spiral metallic foil pattern (12a) formed on a first face of said insulator substrate (15); and
   a second substantially spiral metallic foil pattern (13a) formed on a second face of said insulator substrate (15), wherein
   said first and second spiral metallic foil patterns (12a, 13a) are not electrically connected with each other, and wherein
   at least respective portions of said first and second spiral metallic foil patterns (12a, 13a) are overlapped with each other with said insulator substrate (15) interposed therebetween so as to provide a mutual electromagnetic coupling.

2. The print coil device of claim 1, further comprising:
   a first metallic foil lead (12b) formed on the second face of said insulator substrate (15); and
   a second metallic foil lead (22b) formed on the first face of said insulator substrate (15), wherein
   said first metallic foil lead (12b) has one end connected to an inner end portion of said first spiral metallic foil pattern (12a) through a hole (23a) formed in said insulator substrate (15), and wherein
   said second metallic foil lead (13b) is connected to an inner end portion of said second spiral metallic foil pattern (13a) through another hole (23b) formed in said insulator substrate (15).

3. The print coil device of claim 2, wherein said first metallic foil lead (12b) has the other end connected to a terminal 21b provided outside said first spiral metallic foil pattern (12a) and penetrating said substrate (15), and

said second metallic foil lead (12a) is connected to another terminal (22b) provided outside said second spiral metallic foil pattern (13a) and penetrating substrate (15).

# FIG.1

## FIG.2A

## FIG.2B

# FIG.3

# FIG.4

European Patent
Office

**EUROPEAN SEARCH REPORT**

Application Number

EP    92 30 0717

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | DE-A-1 563 464 (TELEFUNKEN)<br>* page 2, last paragraph - page 3 *<br>--- | 1-3 | H01F27/28<br>H01F5/00 |
| A | EP-A-0 338 660 (SCIENTIFIC GENERICS)<br>--- | | |
| A | US-A-3 717 835 (WILLIAM H. ROADSTRUM)<br>--- | | |
| A | FR-A-1 109 521 (J. VISSEAUX S.A.)<br><br>----- | | |
| | | | TECHNICAL FIELDS SEARCHED (Int. Cl.5 )<br><br>H01F |

The present search report has been drawn up for all claims

| Place of search | Date of completion of the search | Examiner |
|---|---|---|
| THE HAGUE | 08 MAY 1992 | VANHULLE R. |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P0401)

9